Europäisches Patentamt

European Patent Office

Office européen des brevets

(19)

(11) Veröffentlichungsnummer: **0 348 393 B1**

# (12) EUROPÄISCHE PATENTSCHRIFT

(45) Veröffentlichungstag der Patentschrift: **26.05.93**

(51) Int. Cl.5: **H03H 17/06**

(21) Anmeldenummer: **88900810.8**

(22) Anmeldetag: **16.01.88**

(86) Internationale Anmeldenummer:
**PCT/DE88/00020**

(87) Internationale Veröffentlichungsnummer:
**WO 88/06381 (25.08.88 88/19)**

(54) **NICHTREKURSIVES HALB-BAND-FILTER.**

(30) Priorität: **19.02.87 DE 3705206**

(43) Veröffentlichungstag der Anmeldung:
**03.01.90 Patentblatt 90/01**

(45) Bekanntmachung des Hinweises auf die
Patenterteilung:
**26.05.93 Patentblatt 93/21**

(84) Benannte Vertragsstaaten:
**AT CH FR GB IT LI SE**

(56) Entgegenhaltungen:
**EP-A- 0 250 926**

**IEEE Transactions on Acoustics, Speech, and Signal Processing, Vol. ASSP-22, Nr. 4, August 1974, IEEE, (NEW YORK, US), M.G. Bellanger et al.: "Interpolation, extrapolation, and reduction of computation speed in digital filters" pages 231-235 see whole document (Cited in the application)**

(73) Patentinhaber: **ANT Nachrichtentechnik GmbH**
**Gerberstrasse 33**
**W-7150 Backnang(DE)**

(72) Erfinder: **GÖCKLER, Heinz**
**Elbinger Strasze 52**
**W-7150 Backnang(DE)**

**Beschreibung**

Die Erfindung bezieht sich auf ein nichtrekursives Halb − Band − Filter. Solche Filter sind bekannt geworden durch den Aufsatz "Interpolation, Extrapolation, and Reduction of Computation Speed in Digital Filters" von Bellanger et al in IEEE Transactions on Acoustics, Speech and Signal Processing, Vol. ASSP − 22, Nr. 4, Aug. 74, S. 231 ff. Die bekannten Halb − Band − Filter verarbeiten reelle Eingangssignale zu reellen Ausgangssignalen.

Der vorliegenden Erfindung lag die folgende Aufgabe zugrunde, ein nichtrekursives Filter anzugeben, welches die Umwandlung eines komplexen Eingangssignals in ein komplexes Ausgangssignal in wenig aufwendiger Weise ermöglicht.

Die Lösung erfolgt mit den Merkmalen des Anspruches 1 und der Ansprüche 2 bis 9.

Das erfindungsgemäße nichtrekursive Halb − Band − Filter gestattet die Umwandlung komplexer digitaler Eingangssignale in komplexe digitale Ausgangssignale ohne Veränderung der Abtastfrequenz. Dieses relativ unaufwendige Halb − Band − Filter eignet sich damit als digitales Vorfilter oder Nachfilter für digitale Systeme zur Verarbeitung komplexer Signale und als digitales Teilfilter einer Anordnung von Antialiasing Filtern zur Bandbegrenzung unter Erfüllung des Abtasttheorems. Der Vorteil des Halb − Band − Filters liegt in der linearen Phase und in dem gleichzeitig geringen Aufwand.

Es folgt nun die Beschreibung anhand der Figuren.

Die Figur 1 zeigt das Blockschaltbild des erfindungsgemäßen Digitalfilters.

In Figur 2a bis 2c sind einige Amplitudenantworten von Halb − Band − Filtern über der Frequenz aufgetragen.

Die Figuren 3 und 4 zeigen besonders günstige Schaltungsvarianten des Halb − Band − Filters.

In Figur 5 schließlich ist das Blockschaltbild eines transponierten, umgekehrt betriebenen Halb − Band − Filters zur Verarbeitung eines komplexen Eingangssignals in ein komplexes Ausgangssignal gezeichnet.

Die Figur 6 zeigt die detaillierte Schaltung des Filters nach Fig. 5, wobei diese Schaltung aus der Figur 3 durch Transposition entwickelt wurde, d.h. durch Umkehrung aller Pfeilrichtungen und den Ersatz einer Verzweigung durch einen Addierer und umgekehrt und den Ersatz eines Demultiplexers durch einen Multiplexer.

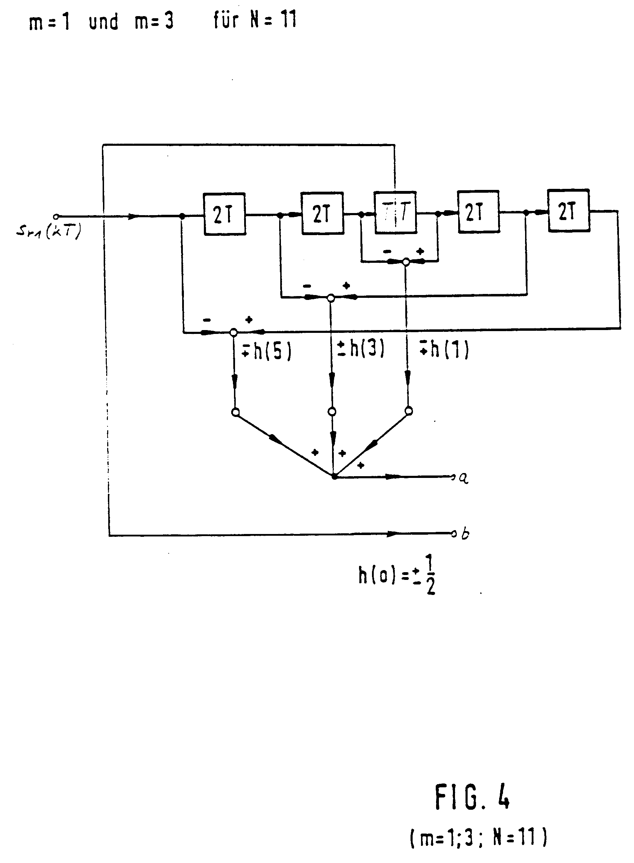

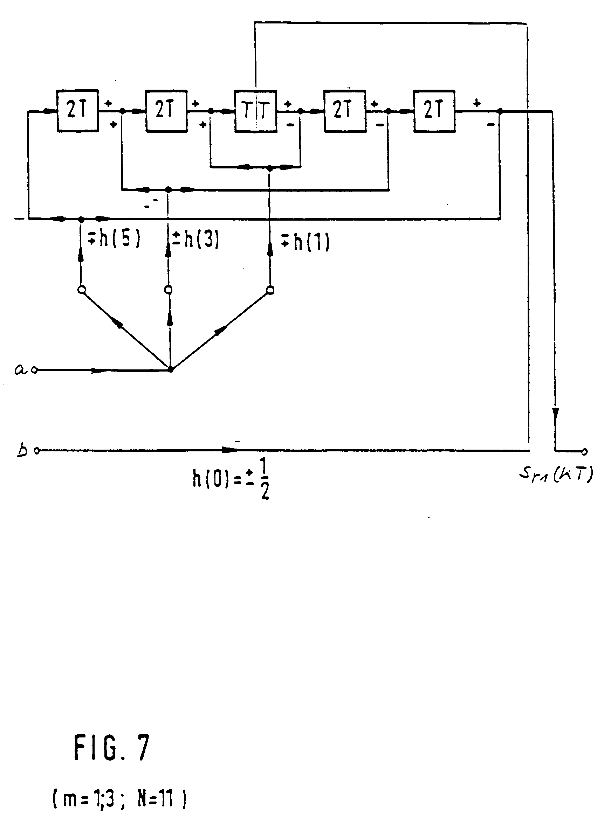

In entsprechender Weise ist die Schaltung nach Figur 7 aus der der Figur 4 entstanden.

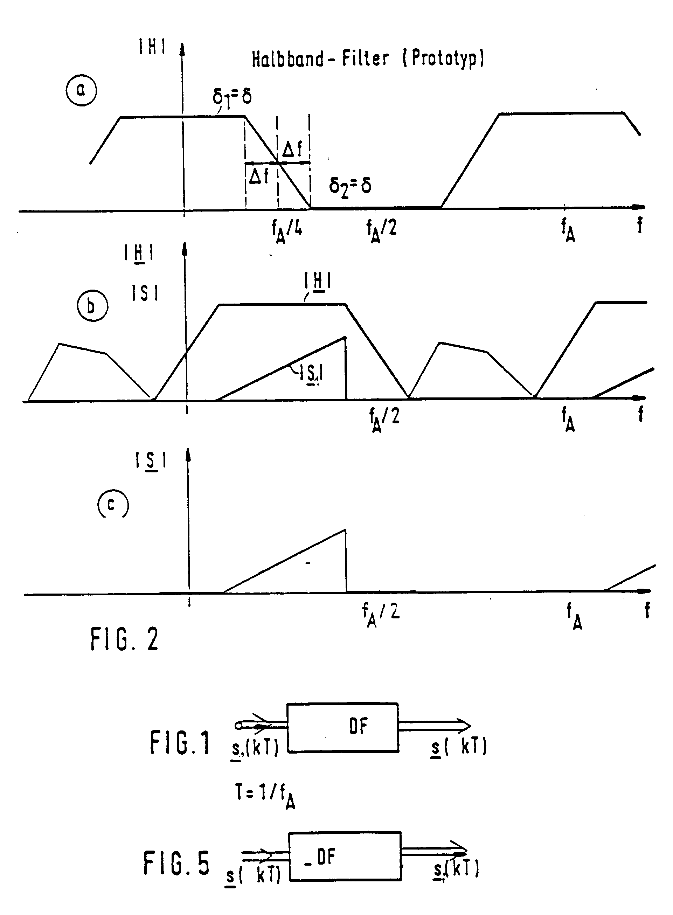

In Figur 1 wird das komplexe Eingangssignal $s_1(kT)$ ohne Veränderung der Abtastrate dem digitalen Halb − Band − Filter DF zugeführt, welches daraus das komplexe Ausgangssignal $s(kT)$ erzeugt.

In Figur 2a ist die Amplitudenfrequenzantwort eines Prototyp − Halb − Band − Filters erkennbar, sein Durch − laßbereich reicht von $-fA/4 + \Delta f$ bis $+fA/4 - \Delta f$ (Halbwert), und sein Sperrbereich ist ebenfalls $fA/2 - 2\Delta f$ breit. Kennzeichnend für das Halb − Band − Filter ist weiterhin, daß aer Übergang vom Sperrzum Durchlaß − bereich stetig ist und auf einer Breite von 2 f erfolgt. Dieser Übergangsbereich ist symmetrisch zu $fA/4$ angeordnet. Ein weiteres Kennzeichen des Halb − Band − Filters ist, daß sein Ripple im Durchlaß − und Sperrbereich gleich ist, nämlich $\delta 1 = \delta 2 = \delta$. Bei einem solchen Filter ergibt sich eine Impulsantwort $h(l)$ mit $l = 0$ bis $N - 1$ und der ungeraden Filterlänge N, und es ergibt sich, daß jeder 2. Wert identisch Null ist, ausgenommen der mittlere Hauptwert (s. hierzu auch Fig. 2 auf S. 233 in dem o.g. Aufsatz von Bellanger et al).

Die Figur 2b zeigt den Frequenzgang $|H|$. Man sieht, daß dieser Frequenzgang um die Frequenz $fA/4$ gegenüber dem Frequenzgang des Prototyp − Halb − Band − Filtersnach rechts verschoben ist. In die Figur 2b ist zusätzlich das Spektrum $|S_1|$ eines komplexen mit der Abtastfrequenz fA abgetasteten Eingangssi − gnals $s_1(kT)$ eingezeichnet, das sich aufgrund der Abtastung mit fA in den Frequenzbereichen $[m \cdot fA, (m+1) \cdot fA]$ mit $m = ... -1, 0, +1 ...$ periodisch wiederholt. Das erfindungsgemäße Halb − Band − Filter wird also die Spektralanteile von $s_1(kT)$ zwischen fA/2 und fA und natürlich mit sämtlichen Wiederholungen unterdrücken.

An dieser Stelle sei erwähnt, daß man am Ausgang des Halb − Band − Filters den anderen Spektralanteil des komplexen Eingangssignals $s_1(kT)$ erhält, wenn der Frequenzgang des Pratotyp − Halb − Band − Filters gemäß Figur 2a um $-fA/4$ oder, was gleichbedeutend ist, um $+3fA/4$ verschoben wird.

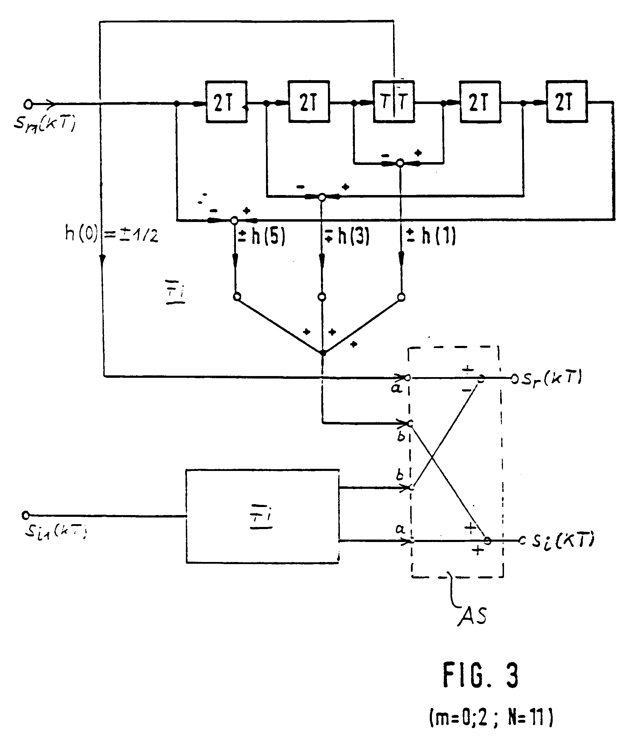

Die Figur 3 zeigt nun ein detaillierteres Ausführungsbeispiel eines erfindungsgernäßen Halb − Band − Filters. Sowohl Figur 3 als auch Figur 4 stellt beispielhaft eine Realisierung dar für eine Filterlänge N = 11 mit einer Kette von 6 Verzögerungsgliedern, davon 4 Verzögerungsglieder der Verzögerungszeit 2T und zwei symmetrisch zwischen den 4 Verzögerungsgliedern eingelagerten Glieder der Verzögerungszeit T.

Die Figur 3 zeigt das komplette Halb − Band − Filter mit den beiden identischen Teilfiltern Fi, wobei das obere zur Verarbeitung des Realteils $s_{r1}(kT)$ und das untere zur Verarbeitung des Imaginärteils $s_{i1}(kT)$ des komplexwertigen Eingangssignals dient. Die Ausgangsgangssignalpaare an den Klemmen a, b sind in einer Ausgangsschaltung AS mit Differenz − und Summierglied verschaltet gemäß Gleichung (1), Patentanspruch

2

1, welche Ausgangsschaltung das komplexe Ausgangssignal $s(kT) = s_r(k) + js_i(k)$ liefert.

In Figur 3 sind nun 2 Realisierungen dargestellt, nämlich für einen Modulationsphasenwinkel $\phi 0 = 0$ und $\phi 0 = \pi$ entsprechend m = 0 und m = 2.

Das Ausgangssignal der Verzögerungsglieder der linken Kettenhälfte wird mit h(0) = 1/2 bewertet (multipliziert) und ergibt damit den einen Beitrag zum Realteil $S_r(kT)$ des Ausgangssignals. Bei m = 2 wird mit − 1/2 bewertet. Die weitere Verarbeitung in der Verzögerungskette erfolgt nun derart, daß (N + 1)/4 = 3 Differenzsignale gebildet werden:

1. Differenzsignal = Eingangssignal des 1. minus Ausgangssignal des letzten Verzögerungsgliedes.

2. Differenzsignal = Eingangssignal des 2. minus Ausgangssignal des zweitletzten Verzögerungsgliedes und

3. Differenzsignal = Eingangssignal des 3. minus Ausgangssignal des drittletzten also des mittleren Verzögerungsgliedes.

Anschließend werden diese Differenzsignale bewertet (multipliziert), summiert und ergeben somit den einen Beitrag zum Imaginärteil des Ausgangssignals s(kT). Die Bewertung erfolgt nach den folgenden Tabellen.

Beispiele für N = 11 und h(−l) = h(l) für l = 0, 1, ...5, entsprechend dem Prototyp − Halb − Band − Filter gemäß Frequenzgang Figur 2a:

Tabelle 1

| m = 0 (m = 2 mit jeweils anderem Vorzeichen der komplexen Koeffizienten $\underline{h} = Re(\underline{h}) + jJm(\underline{h})$) | | | | | | | |
|---|---|---|---|---|---|---|---|
| l | − 5 | − 3 | − 1 | 0 | 1 | 3 | 5 |
| Re($\underline{h}$) | 0 | 0 | 0 | h(0) | 0 | 0 | 0 |
| Jm($\underline{h}$) | − h(5) | h(3) | − h(1) | 0 | h(1) | − h(3) | h(5) |

Tabelle 2

| m = 1 (m = 3 mit jeweils anderen Vorzeichen der komplexen Koeffizienten) | | | | | | | |
|---|---|---|---|---|---|---|---|
| l | − 5 | − 3 | − 1 | 0 | 1 | 3 | 5 |
| Re($\underline{h}$) | h(5) | − h(3) | h(1) | 0 | − h(1) | h(3) | − h(5) |
| Jm($\underline{h}$) | 0 | 0 | 0 | h(0) | 0 | 0 | 0 |

Die Realisierung gemäß Fig. 4 erfolgt in der gleichen Weise wie die nach der Figur 3, der Unterschied liegt allein im anderen Nullphasenwert $\phi 0 = m \cdot \pi/2$ mit m = 1 und 3, was lediglich eine andere Bewertung zur Folge hat.

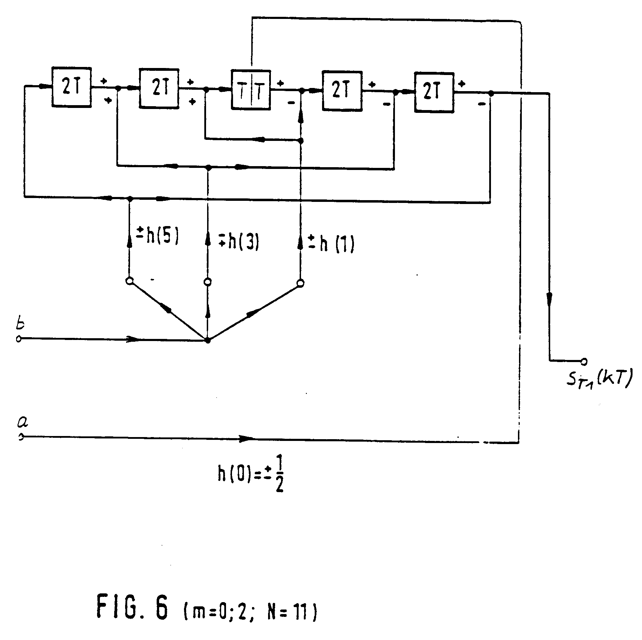

Die Figur 5 zeigt das Blockschaltbild für den umgekehrten Einsatz des Halb − Band − Filters nach Figur 1 ebenfalls zur Erzeugung eines komplexen Ausgangssignals aus einem komplexen Eingangssignal. Hierzu hat eine Transposition der bisher vorgestellten Schaltungen zu erfolgen, was eine Umkehrung aller Pfeilrichtungen und ein Ersatz einer Verzweigung durch einen Addierer und umgekehrt zur Folge hat. In entsprechender Weise gehen das Schaltungsausführungsbeispiel der Figur 6 aus der Figur 3 und die Schaltung nach Figur 7 aus Figur 4 hervor.

**Patentansprüche**

1. Nichtrekursives Halb − Band − Filter, dadurch gekennzeichnet, daß sein komplexwertiges Eingangssignal $\underline{s}_1(kT) = s_{r1} + js_{i1}$ unter Beibehaltung der Abtastfrequenz fA = 1/T und mittels Faltung

$$\underline{s}(kT) = \underline{s}_1(kT) * \underline{h}(l)$$
$$= s_{r1}(k) * h_r(l) - s_{i1}(k) * h_i(l)$$
$$+ j [s_{r1}(k) * h_i(l) + s_{i1}(k) * h_r(l)] \quad (1)$$

in ein komplexwertiges Ausgangssignal s(k) mit k als laufendem Index umgewandelt wird, indem seine Impulsantwort h(l), mit l = −(N−1)/2 bis (N−1)/2 und der ungeraden Filterlänge N, auf den komplexen Träger einer Frequenz von ± 1/4 der Abtastfrequenz fA = 1/T moduliert wird zu

$$\underline{h}(l) = h(l) \cdot e^{j(\pm 2\pi l fA/4fA + \phi 0)} = j^{\pm l} \cdot e^{j \cdot \phi 0} \cdot h(l)$$

und
daß die Nullphase $\phi 0$ dieser Frequenz ganze Vielfache m von $\pi/2$ beträgt

( $\phi 0$ = m . $\pi/2$ mit m = 0, 1, 2, 3 ...).

**2.** Nichtrekursives Halb−Band−Filter nach Anspruch 1, mit Verzögerungsgliedern, Signalverzweigungen, Addierern, dadurch gekennzeichnet, daß es einer Transposition unterzogen wurde, indem sämtliche Signalrichtungen und Verzögerungsglieder umgekehrt wurden und Addierer durch Signalverzweigungen und Signalverzweigungen durch Addierer ersetzt wurden. Verzögerungszeit 2T geleitet wird, wobei das mittlere Verzögerungsglied aufgetrennt ist in zwei Glieder mit der Verzögerungszeit T,
daß jeweils Differenzsignale gebildet werden aus Ausgangssignal des letzten Verzögerungsgliedes minus Eingangssignal des 1. Verzögerungsgliedes = 1. Differenzsignal, Ausgangssignal des zweitletzten Verzögerungsgliedes minus Eingangssignal des 2. Verzögerungsgliedes = 2. Differenzsignal, Ausgangssignal des drittletzten Verzögerungsgliedes minus Eingangssignal des

**3.** Verzögerungsgliedes = 3. Differenzsignal usw.,
daß diese Differenzsignale einer Bewertung (Multiplikation) mit einem Wert h(l) der Impulsantwort unterworfen werden und anschließend summiert werden und dann den einen Term zum Real− bzw. Imaginärteil des Filterausgangssignals s(kT) ergeben,
daß aus der Kettenmitte, also nach einer Verzögerungszeit T•(N − 1)/2, ein Ausgangssignal mit dem Wert h(0) bewertet wird, welches den einen Term zum Imaginär− bzw. Realteil des Filterausgangssignals s(kT) ergibt.

**4.** Nichtrekursives Halb−Band−Filter nach Anspruch 3, mit N = 11 und m = 1, dadurch gekennzeichnet, daß das 1. Differenzsignal mit −h(5), das 2. Differenzsignal mit h(3) und das 3. mit −h(1) bewertet werden und daß h(0) = 1/2 ist.

**5.** Nichtrekursives Halb−Band−Filter nach Anspruch 3, mit N = 11 und m = 3, dadurch gekennzeichnet, daß die Bewertung des 1. Differenzsignals mit h(5), des 2. mit −h(3), des 3. mit h(1) erfolgt und daß h(0) = −1/2 ist.

**6.** Nichtrekursives • Halb−Band−Filter nach Anspruch 3, mit N = 11 und m = 0, dadurch gekennzeichnet, daß die Bewertung des 1. Differenzsignals mit h(5), des 2. mit −h(3) und des 3. mit h(1) erfolgt und daß h(0) = 1/2 ist.

**7.** Nichtrekursives Halb−Band−Filter nach Anspruch 3, mit N = 11 und m = 2, dadurch gekennzeichnet, daß die Bewertung des 1. Differenzsignals mit −h(5), des 2. mit h(3), des 3. mit −h(1) erfolgt und daß h(0) = −1/2 ist.

**8.** Nichtrekursives Halb−Band−Filter nach Anspruch 2, dadurch gekennzeichnet, daß in einem 1. Teilfilter (Fi) zur Erarbeitung des Realteils $s_{r1}$(kT) und in einem 2. Teilfilter (Fi) zur Erarbeitung des Imaginärteils $s_{i1}$(kT) jeweils eine Kette von (N−1)/2 Verzögerungsgliedern der Verzögerungszeit 2T vorgesehen ist, wobei das innere Verzögerungsglied aufgetrennt ist in zwei Glieder mit der Verzögerungszeit T,
daß das mit einem Wert h(l) der Impulsantwort bewertete Eingangssignal dem 1. Verzögerungsglied dieser Kette zugeführt und vom Ausgangssignal des letzten Verzögerungsgliedes dieser Kette abgezogen wird, welches Differenzsignal den Realteil $s_{r1}$(kT) bzw. den Imaginärteil $S_i$(kT) des komplexen Filterausgangssignals $s_1$(kT) liefert,
daß auf das Transversalsignal dieser Verzögerungsgliederkette an den weiteren Punkten zusätzliche mit einem Wert h(l) der Impulsantwort bewertete Augenblickswerte des Filtereingangssgnals addiert werden,
daß in die Mitte der Verzögerungskette des 1. Teilfilters der Imaginörteil $S_i$(kT) und in die Mitte des 2. Teilfilters der Realteil $S_r$(kT) mit h(0) bewertet, eingegeben wird.

4

9. Nichtrekursives Halb‑Band‑Filter nach Anspruch 8, mit m = 0 bzw. 2 und N = 11, <u>dadurch gekennzeichnet</u>, daß die Bewertung der zugeführten Augenblickswerte des Realteils $s_r(kT)$ bzw. des Imaginärteils $S_i(kT)$ des komplexen Filtereingangssignals wie folgt erfolgt:
am Eingang des 1. Verzögerungsgliedes ±h(5),
am Eingang des 2. Verzögerungsgliedes ±h(3),
am Eingang des 3. Verzögerungsgliedes ±h(1),
am Eingang des zweitletzten Verzögerungsgliedes ±h(1),
am Eingang des letzten Verzögerungsgliedes ±h(3) und
am Ausgang des letzten Verzögerungsgliedes ±h(5) und
daß h(0) = ±1/2 ist.

## Claims

1. A non‑recursive half‑band filter, <u>characterised in that</u> its complex input signal $s_1(kT) = s_{r1} + js_{i1}$ is converted, without changing the sampling frequency fA = 1/T and by means of convolution

$$\underline{s}(kT) = \underline{s}_1(kT) * \underline{h}(\ell)$$
$$= s_{r1}(k) * h_r(\ell) - s_{i1}(k) * h_i(\ell)$$
$$+ j[s_{r1}(k) * h_i(\ell) + s_{i1}(k) * h_r(\ell)] \qquad (1)$$

into a complex output signal s(kT) where k is a running index in that its pulse response $h(\ell)$, where $\ell = -(N-1)/2$ to $(N-1)/2$ and N is an odd filter length, is modulated onto the complex carrier at a frequency of $\pm\frac{1}{4}$ of the sampling frequency fA = 1/T, to yield

$$\underline{h}(\ell) = h(\ell) \cdot e^{j(\pm2\pi\ell fA/4fA + \phi0)} = j^{\pm\ell} \cdot e^{j\phi0} \cdot h(\ell)$$

and the null phase $\phi0$ of this frequency is an integer multiple m of $\pi/2$ ($\phi0 = m \cdot \pi/2$ where m = 0, 1, 2, 3, ...).

2. A non‑recursive half‑band filter according to claim 1, including delay members, signal branching switches, adders, characterised in that it was subjected to a transposition in that all signal directions and delay members were reversed and adders were replaced with signal branching switches and signal branching switches were replaced with adders.

3. A non‑recursive half‑band filter according to claim 1, <u>characterised in that</u> each sample of the real and the imaginary component of the input signal $s_1(kT)$ is routed into a chain of $(N-1)/2$ delay members having delay times of 2T, with the center delay member being divided into two members having a delay time of T; in each case difference signals are formed from the output signal of the last delay member minus the input signal of the first delay member to equal the first difference signal; from the output signal of the penultimate delay member minus the input signal of the second delay member to equal the second difference signal; from the output signal of the third last delay member minus the input signal of the third delay member to equal the third difference signal, etc; these difference signals are subjected to weighting (multiplication) with a value $h(\ell)$ of the pulse response and are then summed, and then yield the one term of the real or the imaginary component of the filter output signal s(kT); from the center of the chain, that is, after a delay of $T \cdot (N-1)/2$, an output signal is weighted with the value h(0), which results in the one term of the imaginary or the real component of the filter output signal s(kT).

4. A non‑recursive half‑band filter according to claim 3, where N = 11 and m = 1, <u>characterised in that</u> the first difference signal is weighted with $-h(5)$, the second difference signal with h(3) and the third difference signal with $-h(1)$; and h(0) = $\frac{1}{2}$.

5. A non‑recursive half‑band filter according to claim 3, where N = 11 and m = 3, <u>characterised in that</u> the first difference signal is weighted with h(5), the second with $-h(3)$, the third with h(1); and h(0) = $-\frac{1}{2}$.

6. A non−recursive half−band filter according to claim 3, where N = 11 and m = 0, characterised in that the first difference signal is weighted with h(5), the second with −h(3), and the third with h(1); and h(0) = $\frac{1}{2}$.

7. A non−recursive half−band filter according to claim 3, where N = 11 and m = 2, characterised in that the first difference signal is weighted with −h(5), the second with h(3), the third with −h(1); and h(0) = −$\frac{1}{2}$.

8. A non−recursive half−band filter according to claim 2, characterised in that a chain of (N−1)/2 delay members having a delay time of 2T is provided in a first partial filter (Fi) for generating the real component $s_{r1}(kT)$ and in a second partial filter (Fi) for generating the imaginary component $s_{i1}(kT)$, with the inner delay member being divided into two members having a delay time of T; the input signal weighted with a value of h(ℓ) of the pulse response is fed to the first delay member of this chain and is subtracted from the output signal of the last delay member of this chain, said difference signal furnishing the real component $s_{r1}(kT)$ and the imaginary component $s_i(kT)$, respectively, of the complex filter output signal $s_1(kT)$; additional momentary values of the filter input signal weighted with a value h(ℓ) of the pulse response are added to the transversal signal of this chain of delay members at further points; the imaginary component $s_i(kT)$ weighted with h(0) is fed into the middle of the delay chain of the first partial filter and the real component $s_r(kT)$ weighted with h(0) is fed into the middle of the second partial filter.

9. A non−recursive half−band filter according to claim 8, where m = 0 and 2, respectively, and N = 11, characterised in that the weighting of the applied momentary values of the real component $s_r(kT)$ and of the imaginary component $s_i(kT)$, respectively, of the complex filter input signal is effected as follows:

at the input of the first delay member with ±h(5);
at the input of the second delay member with ±h(3);
at the input of the third delay member with ±h(1);
at the input of the penultimate delay member with ±h(1);
at the input of the last delay member with ±h(3); and
at the output of the last delay member with ±h(5); and h(0) = ±$\frac{1}{2}$.

## Revendications

1. Filtre de demi−bande non récurrent, caractérisé en ce que son signal d'entrée de valeur complexe $s_1$ (kT) = $s_{rl}$ + $js_{i1}$ est converti, avec maintien de la fréquence d'échantillonnage fA = 1/T et par convolution

$$\underline{s}(kT) = \underline{s}_1(kT) * \underline{h}(l)$$
$$= s_{r1}(k) * h_r(l) - s_{i1}(k) * h_i(l)$$
$$+ j\,[s_{r1}(k) * \hat{h}_i(l) + s_{i1}(k) * h_r(l)] \quad (1)$$

en un signal de sortie de valeur complexe s(k) avec k comme indice courant, du fait que sa réponse impulsionnelle h(l), avec l = −(N−1)/2 à (N−1)/2 et la longueur de filtre impaire N, est modulée sur le porteur complexe d'une fréquence de ± 1/4 de la fréquence d'échantillonnage fA = 1/T, pour donner

$$\underline{h}(l) = h(l) \cdot e^{j(+2\pi l fA/4fA + \phi 0)} = j^{\pm l} \cdot e^{j \cdot \phi 0} \cdot h(l)$$

et que la phase nulles $\phi 0$ de cette fréquence correspond à des multiples entiers m de $\pi/2$ ( $\phi 0$ = m $\cdot$ $\pi/2$ avec m = 0, 1, 2, 3 ...).

2. Filtre de demi−bande non récurrent selon la revendication 1, comprenant des éléments de retard, des ramifications de signal et des additionneurs, caractérisé en ce qu'il a été soumis à une transposition du fait que toutes les directions de signal et tous les éléments de retard ont été inversés, les additionneurs ont été remplacés par des ramifications de signal et les ramifications de signal ont été remplacées par des additionneurs.

3. Filtre de demi − bande non récurrent selon la revendication 1, caractérisé en ce que chaque valeur d'échantillonnage de la partie réelle et de la partie imaginaire du signal d'entrée $s_1(kT)$ est introduite chaque fois dans une chaîne de $(N − 1)/2$ éléments de retard ayant le temps de retard 2T, l'élément de retard du milieu de la chaîne étant divisé en deux éléments ayant le temps de retard T,

que des signaux de différence sont formés chaque fois à partir du signal de sortie du dernier élément de retard moins le signal d'entrée du premier élément de retard = le premier signal de différence; du signal de sortie de l'avant − dernier élément de retard moins le signal d'entrée du deuxième élément de retard = le deuxième signal de différence; du signal de sortie de l'avantavant dernier élément de retard moins le signal d'entrée du trosième élément de retard = le troisième signal de différence, et ainsi de suite,

que ces signaux de différence sont soumis à une pondération (multiplication) par une valeur h(l) de la réponse impulsionnelle puis totalisés et fournissent alors l'un des termes de la partie réelle ou de la partie imaginaire du signal de sortie du filtre s(kT) et qu'un signal de sortie issu du milieu de la chaîne, c'est − à − dire obtenu après un temps de retard $T \cdot (N − 1)/2$, est pondéré de la valeur h(0), signal qui fournit l'un des termes de la partie imaginaire ou de la partie réelle du signal de sortie de filtre s(kT).

4. Filtre de demi − bande non récurrent selon la revendication 3, avec N = 11 et m = 1, caractérisé en ce que le premier signal de différence est pondéré de − h(5), le deuxième signal de différence est pondéré de h(3) et le troisième signal de différence est pondéré de − h(1), et que h(0) = 1/2.

5. Filtre de demi − bande non récurrent selon la revendication 3, avec N = 11 et m = 3, caractérisé en ce que la pondération du premier signal de différence s'effectue par h(5), du deuxième signal de différence par − h(3) et du troisième signal de différence avec h(1) et que h(0) = − 1/2.

6. Filtre de demi − bande non récurrent selon la revendication 3, avec N = 11 et m = 0, caractérisé en ce que la pondération du premier signal de différence s'effectue par h(5), du deuxième signal de différence par − h(3) et du troisième signal de différence par h(1) et que h(0) = − 1/2.

7. Filtre de demi − bande non récurrent selon la revendication 3, avec N = 11 et m = 2, caractérisé en ce que la pondération du premier signal de différence s'effectue par − h(5), du deuxième par h(3), et du troisième par − h(1) et que h(0) = − 1/2.

8. Filtre de demi − bande non récurrent selon la revendication 2, caractérisé en ce que, dans un premier filtre partiel (Fi) pour l'élaboration de la partie réelle $s_{r1}(kT)$ et dans un deuxième filtre partiel (Fi) pour l'élaboration de la partie imaginaire $s_{i1}(kT)$, on a prévu chaque fois une chaîne de $(N − 1)/2$ éléments de retard ayant le temps de retard 2T, l'élément de retard du milieu étant divisé en deux éléments ayant le temps de retard T,

que le signal d'entrée, pondéré d'une valeur h(l) de la réponse impulsionnelle, est appliqué au premier élément de retard de cette chaîne et déduit du signal de sortie du dernier élément de retard de la chaîne, le signal de différence ainsi obtenu fournissant la partie réelle $S_{r1}(kT)$ ou la partie imaginaire $s_i(kT)$ du signal de sortie de filtre complexe $s_1(kT)$,

que des valeurs instantanées supplémentaires du signal d'entrée du filtre, pondérées d'une valeur h(l) de la réponse impulsionnelle, sont additionnées aux autres points au signal transversal de cette chaîne d'éléments de retard et

que la partie imaginaire $s_i(kT)$ est introduite au milieu de la chaîne d'éléments de retard du premier filtre partiel et la partie réelle $s_r(kT)$, pondérée de h(0), est introduite au milieu du deuxième filtre partiel.

9. Filtre de demi − bande non récurrent selon la revendication 8, avec m = 0 ou 2 et N = 11, caractérisé en ce que la pondération des valeurs instantanées appliquées de la partie réelle $s_r(kT)$ ou de la partie imaginaire $s_i(kT)$ du signal d'entrée complexe du filtre s'effectue comme suit:

par ±h(5) à l'entrée du premier élément de retard,

par ±h(3) à l'entrée du deuxième élément de retard,

par ±h(1) à l'entrée du troisième élément de retard,

par ±h(1) à l'entrée de l'avant − dernier élément de retard,

par ±h(3) à l'entrée du dernier élément de retard et

par ±h(5) à la sortie du dernier élément de retard et

que h(0) = ±1/2.

FIG. 2

FIG.1

$T = 1/f_A$

FIG.5

FIG. 3

(m=0;2 ; N=11)

m = 1 und m = 3 für N = 11

$S_{r1}(kT)$

$\mp h(5)$  $\pm h(3)$  $\mp h(1)$

$h(o) = \pm \frac{1}{2}$

FIG. 4

( m = 1 ; 3 ; N = 11 )

FIG. 6 (m=0;2; N=11)

FIG. 7

$(\ m = 1,3\ ;\ N=11\ )$